# EUROPÄISCHE PATENTSCHRIFT

(11) **EP 2 881 690 B1**
(45) Veröffentlichungstag und Bekanntmachung des Hinweises auf die Patenterteilung: **17.08.2016**
(21) Anmeldenummer: 14196998.0
(22) Anmeldetag: 09.12.2014
(51) Int. Cl.: F28D 20/02, H01L 23/427, H05K 7/20, F28D 15/02

(54) **Kühlvorrichtung zur Abfuhr eines Wärmestromes**
Cooling device for removal of a heat flow
Dispositif de refroidissement destiné à l'évacuation d'un flux thermique

(30) Priorität: 09.12.2013 DE 102013113699
(43) Veröffentlichungstag der Anmeldung: 10.06.2015
(73) Patentinhaber: TuTech Innovation GmbH, 21079 Hamburg (DE); Technische Universität Hamburg-Harburg, 21073 Hamburg (DE)
(72) Erfinder: Schmitz, Gerhard, 21079 Hamburg (DE)
(74) Vertreter: Hauck Patentanwaltspartnerschaft mbB

(56) Entgegenhaltungen:
- WO-A1-03/057795
- WO-A1-2011/025487
- US-A1- 2009 180 250
- US-B1- 6 205 803
- US-B1- 6 397 618

## Beschreibung

Die vorliegende Erfindung betrifft eine Kühlvorrichtung zur Abfuhr eines Wärmestromes, wie sie beispielsweise im Zusammenhang mit der Kühlung von Leistungselektronik eingesetzt wird.

Elektronikkomponenten zur Steuerung und Regelung von Verbrauchern mit hohen elektrischen Strömen, wie beispielsweise Antriebe für Landeklappen bei Flugzeugen, haben wegen des nicht kontinuierlichen Betriebs eine zeitlich schwankende Oberflächentemperatur, die zudem örtlich inhomogen ist. Auf der Oberfläche entstehende heiße Stellen ("Hot Spots"), in denen eine vorgegebene maximale Oberflächentemperatur zuerst überschritten wird, können ohne ausreichende Kühlung an der Oberfläche auftreten. Neben der Kühlung von Elektronikkomponenten ist auch bei Bremsvorgängen, Batterien oder einer exothermem Reaktion im Rahmen der chemischen Prozessführung eine Kühlung oftmals erforderlich.

Es ist bekannt, zur Kühlung von Hot Spots Kühlplatten, sogenannte Cold Plates, einzusetzen. Bei diesen Platten dient ein flüssiges Kühlmittel zur Abfuhr der Wärme. Das Kühlmittel wird über Rohrleitungen zu einer Wärmesenke geführt, wo es die aufgenommene Wärme abgibt. Für einen bestimmten abzuführenden Wärmestrom ist bei einer bestimmten Temperatur ein physikalisch bedingter Massenstrom an Kühlmittel und damit eine bestimmte Gesamtmasse an Kühlmittel erforderlich. Die erforderliche Kühlmittelmenge ergibt sich zum einen aus den Stoffeigenschaften des Kühlmittels, wie beispielsweise die spezifische Wärmekapazität bei konstantem Druck und zum anderen aus dem Wärmeübertragungskoeffizienten in der Kühlplatte. Der Wärmeübertragungskoeffizient hängt von der Strömungsgeschwindigkeit des Kühlmittels ab. Um gute Wärmeübertragungskoeffizienten und damit gute Kühleigenschaften zu erzielen, müssen hohe Strömungsgeschwindigkeiten erreicht werden, was hohe Massenströme verlangt.

Entscheidend ist, dass das Kühlsystem stets für den ungünstigsten Fall auszulegen ist, also für die höchste Temperatur und für den größten maximal auftretenden Wärmestrom, auch wenn der nur kurzzeitig auftritt. Dies macht solche Kühlsysteme schwer und teuer.

Weiterhin sind Latentwärmespeicher bekannt, bei denen ein Phasenwechselmaterial bei einer bestimmten Temperatur von seiner festen in die flüssige Phase übergeht. In diesem Phasenübergang kann Wärme in Form von latenter Wärme aufgenommen werden.

Aus DE 10 2008 042 788 A1 ist ein Haushalts-Kältegerät mit Latentwärmespeicher, bekannt, das ein Gehäuse und mindestens einen innerhalb des Gehäuses angeordneten Kühlraum aufweist. In dem Kühlraum ist ein Kühlfach mit einem Latentwärmespeicher zur Kühlung des Kühlfachs vorgesehen. Hierbei handelt es sich um einen Kälte- und nicht um einen Kühlprozess.

Aus DE 10 2010 043 245 A1 ist ein Haushalts-Kältegerät mit einer Kältemaschine bekannt, das einen ein Speicherfluid enthaltenden Pufferspeicher aufweist, der mit wenigstens einem Phasenwechselmaterial in thermischem Kontakt steht. Auch hierbei handelt es sich um einen Kälteprozess und nicht um einen Kühlprozess.

Aus DE 20 2005 017 835 U1 ist ein Latentwärmespeicher mit mindestens einem und wenigstens einem Auslass für ein dem Latentwärmespeicher durchströmendes Wärmetauschmedium bekannt. Der Latenwärmespeicher weist ein Gehäuse auf, in dessen Inneren mit einem Speichermedium gefüllte Speicherräume vorgesehen sind, die unter Freilassung zumindest einer Durchstromöffnung derart in dem Gehäuse angeordnet sind, dass ihre generelle Ausrichtung im Wesentlichen jeweils zueinander parallel erfolgt. Der Latentwärmespeicher ist für die Anwendung in der Gehäusetechnik vorgesehen. Es wird kein verdampfendes Kühlmittel eingesetzt.

Aus WO 2012/123036 A1 ist ein Kühlgerät, insbesondere ein Haushalts-Kühlgerät, bekannt, das eine Lagerkammer für Kühlgut, einen in thermischem Kontakt mit der Lagerkammer angeordneten, intermittierend arbeitenden Verdampfer und einen dem Verdampfer zugeordneten Wärmespeicher aufweist, dessen Speichermedium in Betriebs- und Ruhephasen des Verdampfers jeweils seine Aggregatzustand ändert. Hierbei handelt es sich ebenfalls um einen Kälte- und nicht um einen Kühlprozess.

Aus WO 2012/152777 A1 ist ein Schaltungsmodul mit Kühlung durch Phasenwechselmaterial bekannt.

Aus DE 10 2010 041 951 A1 ist ein Kältegerät mit einem Kältespeicher bekannt, das zwei Kältekreisläufe besitzt.

Aus DE 10 2009 007 786 A1 ist ein Latentwärmespeicher für kryogene Temperaturen bekannt, bei denen für den Arbeitsstoff der Gibbs-Thomson-Effekt ausgenutzt wird.

Aus DE 101 57 671 A1 ist ein optimierter Einsatz eines Phasenwechselmaterials für Kühlvorrichtungen bekannt. Der Kühlstrom durchläuft hierbei keinen Phasenwechsel.

Aus DE 100 48 536 A1 ist ein dynamischer Latentwärmespeicher bekannt, bei dem das Latentwärmespeichermaterial aus kleinen, gesonderten, unverkleideten Mediumelementen besteht, zwischen deren Strömungswegen ein Wärmetransportmedium strömt.

Aus DE 100 19 931 C1 ist ein aktives, thermisches Bauelement bekannt, das ein Phasenwechselmaterial in gekapselter Form enthält.

Aus DE 39 38 875 A1 ist ein mobiles und transportables Klimagerät zur Kühlung und Klimatisierung innenliegender Räume bekannt.

Aus DE 41 08 370 A1 ist ein quasidynamischer Latentwärmespeicher bekannt. Der quasidynamische Wärmespeicher besteht aus einem geschlossenen Behälter mit boden- und deckenseitigen Wärmeüberträgern. Der Behälter enthält Latentwärmespeichermaterial und eine Wärmetransportflüssigkeit. Das Latentwärmespeichermaterial befindet sich im Wärmespeicher in Behälterteilen mit flexiblen Wänden. Der eine Speicherraum ist mit diesen Behälterteilen so ausgefüllt, dass zwischen dem bodenseitigen und dem deckenseitigen Wärmeüberträger Strömungskanäle verbleiben.

US 6 397 618 B1 offenbart eine Kühlvorrichtung gemäß dem Oberbegriff des Anspruchs 1.

Der Erfindung liegt die Aufgabe zugrunde, eine Kühlvorrichtung zur Abfuhr eines Wärmestromes bereitzustellen, die nach Möglichkeit kompakt gebaut ist und zuverlässig arbeitet.

Erfindungsgemäß wird die Aufgabe durch eine Kühlvorrichtung mit den Merkmalen aus Anspruch 1 gelöst. Vorteilhafte Ausgestaltungen bilden den Gegenstand der Unteransprüche.

Die erfindungsgemäße Kühlvorrichtung ist vorgesehen und bestimmt zur Abfuhr eines Wärmestroms. Sie kann insbesondere bei auftretenden Hot Spots in der

Leistungselektronik, aber auch für andere Zwecke, zum Kühlen verwendet werden. Die Kühlvorrichtung besitzt einen Kühlkörper und ein Kühlmittel, das in einem Kühlkreislauf durch den Kühlkörper geführt wird. Der Kühlkörper steht mit einem Latentwärmespeicher in thermischer Verbindung, wobei ein Phasenwechselmaterial des Latentwärmespeichers eine Phasenübergangstemperatur besitzt. Erfindungsgemäß ist die Phasenübergangstemperatur des Latentwärmespeichers auf eine vorbestimmte Siedetemperatur des Kühlmittels abgestimmt. Bei der Wärmeaufnahme verdampft das Kühlmittel mit konstanter Temperatur, der Siedetemperatur. Die Siedetemperatur des Kühlmittels ist kleiner als die Phasenübergangstemperatur des Phasenwechselmaterials. Das Phasenwechselmaterial bleibt daher weitgehend fest.

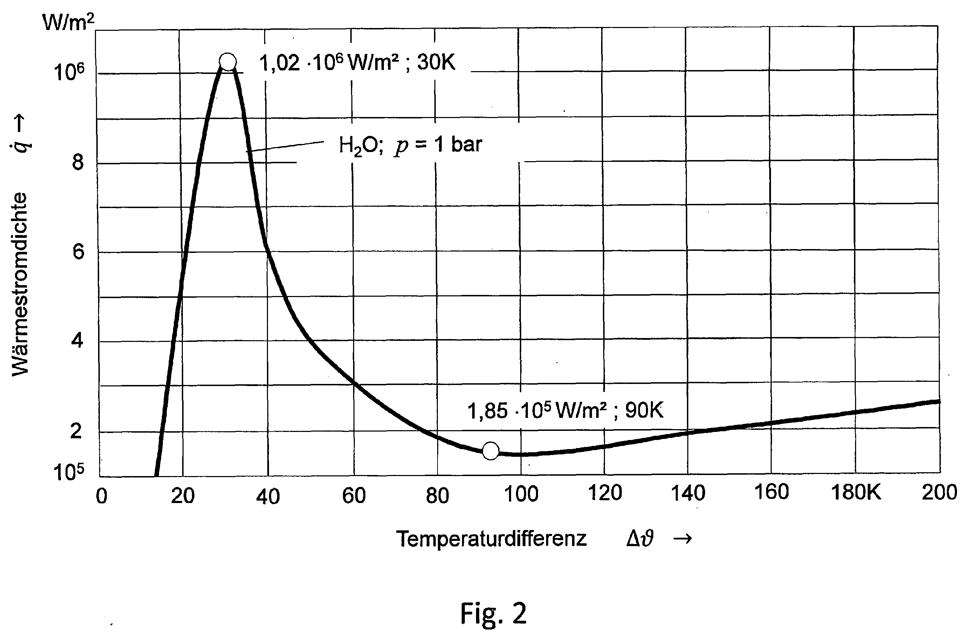

Im Falle eines plötzlich ansteigenden Wärmestroms von der Elektronikkomponente besteht die Gefahr eines Abfalls des Wärmeüberganges vom Kühlkörper zum Kühlmittel. Bei freier Strömung hängt nach Nukijama beim Verdampfen oder Kondensieren die Wärmestromdichte stark von der Temperaturdifferenz ab. Ein entsprechender Zusammenhang ist beispielhaft in Fig. 2 für Wasser bei Atmosphärendruck dargestellt. Das Verhalten von Wasser bei freier Strömung kann leicht plausibel gemacht werden. Mit steigender Temperaturdifferenz zwischen Heizfläche und Fluid bilden sich vermehrt Dampfblasen in dem Wasser aufgrund des Phasenübergangs. Diese Dampfblasen steigen nach oben und verbessern damit den konvektiven Wärmeübergang. Somit steigt die Wärmestromdichte zunächst an. Ab einer bestimmten Temperaturdifferenz zwischen Heizfläche und Fluid sind die sich bildenden Blasen so groß, dass sie einen großen Teil des Bodens bedecken und damit die Wärmeübertragung behindern. Der übertragene Wärmestrom sinkt schlagartig ab. Das Maximum wird als Burn-Out-Punkt bezeichnet.

Bei einer erzwungenen Strömung, beispielsweise durch Rohre, wie sie in einer Kühlplatte vorliegt, sind die Erscheinungen noch etwas verwickelter. Bei kleinen Volumenanteilen des Dampfes tritt ein Filmsieden auf. Bei Erreichen einer kritischen Wärmestromdichte bildet sich ein Dampffilm, der die Flüssigkeit von der Heizwand trennt. Der hohe Wärmewiderstand des Dampffilms führt bei gleichbleibender, eintretender Wärmestromdichte zu einem Anstieg der Temperatur des Kühlkörpers. Mit größer werdendem Dampfgehalt im Laufe des Strömungsweges trocknet die Heizfläche völlig aus, man spricht hier dann wieder von einem Burnout. In diesem Fall steigt die Temperatur des nun überhitzten Kühlmitteldampfes schlagartig an und damit auch die Temperatur des Kühlkörpers. Für eine Kühlung mit einem verdampfenden Kühlmittel verdeutlicht dieser Zusammenhang, dass bei einer zu kühlenden Komponente, an der eine plötzliche Wärmelast anfällt, die eine Erhöhung der Oberflächentemperatur bewirkt, stets die Gefahr besteht, dass das Kühlmittel über den Burn-Out-Punkt getrieben wird oder schon vor dem Austritt aus der Kühlplatte völlig verdampft und so die Kühlung zusammenbricht. Aus diesem Grund konnte auch für gewisse Einsatzmöglichkeiten, wie beispielsweise die Kühlung von Elektronikkomponenten oder Hochleistungselektronikkomponenten bisher keine Verdampfungskühlung eingesetzt werden. Erfindungsgemäß sieht die Kühlvorrichtung nun vor, dass die Phasenübergangstemperatur des Phasenwechselmaterials so eingestellt wird, dass bei einem Anstieg der vorgesehenen Kühlkörper-Oberflächentemperatur die Wärmemenge durch den Latentwärmespeicher aufgenommen und abtransportiert werden kann. Erste überschlägige Betrachtungen haben hierzu ergeben, dass die Kombination beider Kühlsysteme und deren Abstimmung auf einander die Kühlung ganz erheblich verbessert.

Bei der Erfindung orientiert sich die Phasenübergangstemperatur des Phasenwechselmaterials an einer zwischen Kühlmittel und Kühlkörper auftretenden kritischen Wärmestromdichte. Für die Einstellung der Phasenübergangstemperatur, die je nach verwendetem Phasenwechselmaterial durch Zusätze und Mischungsverhältnisse auf weite Bereiche eingestellt werden kann, wird erfindungsgemäß berücksichtigt, dass der Zusammenbruch der Wärmestromdichte nach der Kurve von Nukijama abhängig von einer Temperaturdifferenz und nicht von einem absoluten Temperaturwert ist.

Bevorzugt erfolgt die Umwandlung dahingehend, dass der gewählte vorbestimmte Temperaturwert für den Phasenübergang bevorzugt mindestens 1 K, besonders bevorzugt mindestens 5 K oberhalb der Siedetemperatur des Kühlmittels liegt, da in diesem Fall das Kühlmittel offenbar vollständig verdampft ist und daher die Temperatur des verdampften Kühlmitteldampfes und damit auch die Kühlkörpertemperatur ansteigt. Eine solche Bestimmung einer absoluten Temperatur als Obergrenze für die Phasenübergangstemperatur ist möglich, wenn beispielsweise angenommen wird, dass der Kühlkörper von einer Umgebungstemperatur kommend durch einen plötzlich einsetzenden Wärmestrom erwärmt wird. Dies erlaubt, zuverlässig einen vorbestimmten Temperaturwert für die Phasenübergangstemperatur festzulegen. Bevorzugt erfolgt die Erwärmung durch eine bei Betriebstemperatur einsetzende Wärmelast, wobei die Betriebstemperatur kleiner als 90°C ist.

In einer weiteren bevorzugten Ausgestaltung weist der Kühlkörper ein Gehäuse auf, in dem der Latentwärmespeicher angeordnet ist, wobei ein Abschnitt des Kühlmittelkreislaufs durch den Latentwärmespeicher läuft. Auch ist es möglich, dass der Kühlmittelkreislauf auf dem Latentwärmespeicher zugeordnet ist, so dass der Wärmestrom erst durch diesen tritt. Ebenso kann der Kühlmittelkreislauf auf dem Latentwärmespeicher angeordnet sein, wobei der Wärmestrom dann direkt in diesen eintritt. Bevorzugt verdampft das Kühlmittel in dem Abschnitt des Kühlmittelkreislaufs, der durch und/oder auf dem Latentwärmespeicher verläuft.

In einer bevorzugten Weiterbildung ist in dem Phasenwechselmaterial des Latentwärmespeichers eine Wärmeleitstruktur vorgesehen, die eine in den Kühlkörper eintretende Wärmemenge verteilt. Für gewöhnlich sind Phasenwechselmaterialien schlechte Wärmeleiter, so dass für einen schnellen Abtransport der Wärme und deren Verteilung in dem Phasenwechselmaterial es sehr hilfreich ist, Wärmeleitstrukturen in dem Latentwärmespeicher vorzusehen.

In einer bevorzugten Weiterbildung verläuft der Kühlmittelkreislauf durch das Phasenwechselmaterial und steht in thermischem Kontakt mit der Wärmeleitstruktur. Als Material für die Wärmeleitstruktur wird bevorzugt Aluminium, Kupfer und/oder Kohlefasermaterial eingesetzt.

Die vorliegende Erfindung wird nachfolgend anhand eines Beispiels näher erläutert.

Die bevorzugte Phasenübergangstemperatur liegt zwischen 50°C und 100°C. Wasser besitzt bei Normaldruck eine Phasenübergangstemperatur von 100°C. Bei der Kühlung von Temperaturen, wie sie bei Elektronikkomponenten, Batterien oder chemischen Prozessen auftreten, können Temperaturwerte von 80°C bis 90°C an der Oberfläche erreicht werden.

Es zeigt:
- Fig. 1: die erfindungsgemäße Kühlvorrichtung in einer schematischen Ansicht,
- Fig. 2: die Nukijama-Kurve für Wasser bei Atmosphärendruck und
- Fig. 3: die kritische Wärmestromdichte bei einer erzwungenen Strömung, abhängig vom Strömungsdampfgehalt.

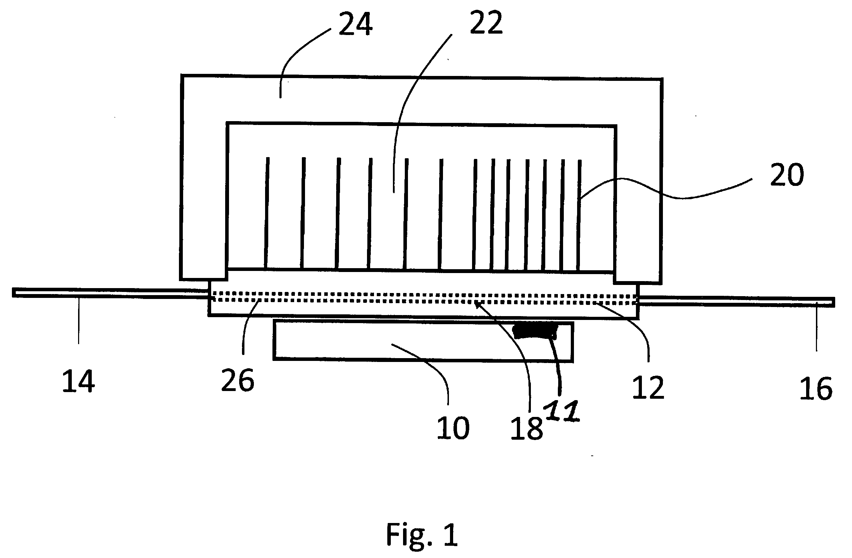

Fig. 1 zeigt in einer schematischen Ansicht die erfindungsgemäße Kühlvorrichtung. Eine Quelle 10 mit einem Hot Spot 11 ist schematisch dargestellt. Hierbei kann es sich beispielsweise um eine Leistungselektronik handeln, die in kurzer Zeit eine große Wärmemenge abgibt. Auf der Wärmequelle ist direkt und in thermischem Kontakt mit dieser eine Kühlplatte 12 angeordnet. Die Kühlplatte 12 besitzt eine Zuleitung 14 für ein Kühlmittel und eine Ableitung 16. Die Zuleitung 14 und die Ableitung 16 sind beispielsweise über eine Kühlmaschine miteinander verbunden, so dass das eingesetzte Kühlmittel die aufgenommene Wärmemenge wieder abgeben kann. In dem zentralen Bereich 18 der Kühlplatte 12 verdampft das Kühlmittel und nimmt dabei eine Wärmemenge auf. Die Kühlleitungen und deren Führung in der Kühlplatte 12 sind nicht näher dargestellt. Auf der von der Wärmequelle abgewandten Seite der Kühlplatte 12 sind Kühlrippen 20 als wärmeleitende Struktur angeordnet. Die Kühlrippen 20 bestehen beispielsweise aus gut wärmeleitendem Metall oder Kohlefasermaterial. Die Kühlrippen müssen nicht symmetrisch oder gleichmäßig beabstandet angeordnet sein. Beispielsweise können die Kühlrippen hin zur Ableitung 16 oder zu einem Hot Spot dichter angeordnet sein, um besser Wärme aus dem Kühlmittel aufnehmen zu können. Ein Phasenwechselmaterial 22 ist zwischen den Kühlrippen 20 innerhalb des Gehäuses 24 angeordnet. Das Phasenwechselmaterial 22 besitzt eine Phasenübergangstemperatur, die so eingestellt ist, dass ein Burn-Out, und damit eine zu starke Erhöung der Oberflächentemperatur der Kühlplatte oberhalb der Siedetemperatur des Kühlmittels 12 vermieden werden. Neben dem Phasenwechselmaterial 22, das außerhalb der Kühlplatte 12 angeordnet ist, kann weiterhin auch ein Phasenwechselmaterial 26 in der Kühlplatte 12 vorgesehen sein.

Fig. 2 zeigt eine Nukijama-Kurve für die Wärmestromtransportdichte von Wasser, das frei fließt und Atmosphärendruck ausgesetzt ist. Die verwendete Abbildung der Nukijama-Kurve ist in Hans Dieter Baehr, Karl Stephan, Wärme- und Stoffübertragung, 3. Auflage, Springer-Verlag, Abb. 4.37, Seite 471 enthalten. Deutlich zu erkennen ist, dass bei einer Temperaturdifferenz bis ungefähr 30K die Wärmestromdichte stark zunimmt. Ist der Differenzwert von 30K überschritten, so nimmt die Wärmestromdichte deutlich ab. Für eine Kühlung mit einem verdampfenden Kühlmittel bedeutet dies, dass stets die Gefahr besteht, dass bei einer zu großen Temperaturdifferenz zwischen zu kühlendem Gegenstand und dem Kühlmittel oder einem zu hohen Dampfgehalt die Wärmestromdichte schlagartig abfällt und es zu einer Überhitzung kommt. Von daher war es in der Vergangenheit notwendig, entsprechende Verdampfungskühlungen sehr groß zu dimensionieren, damit ein Überhitzen nicht auftreten kann. Mit der erfindungsgemäßen Verwendung eines Latentwärmespeichers, dessen Phasenübergangstemperatur knapp oberhalb der Siedetemperatur des Kühlmittels liegt, kann der schlagartige Abfall der Wärmestromdichte vermieden werden.

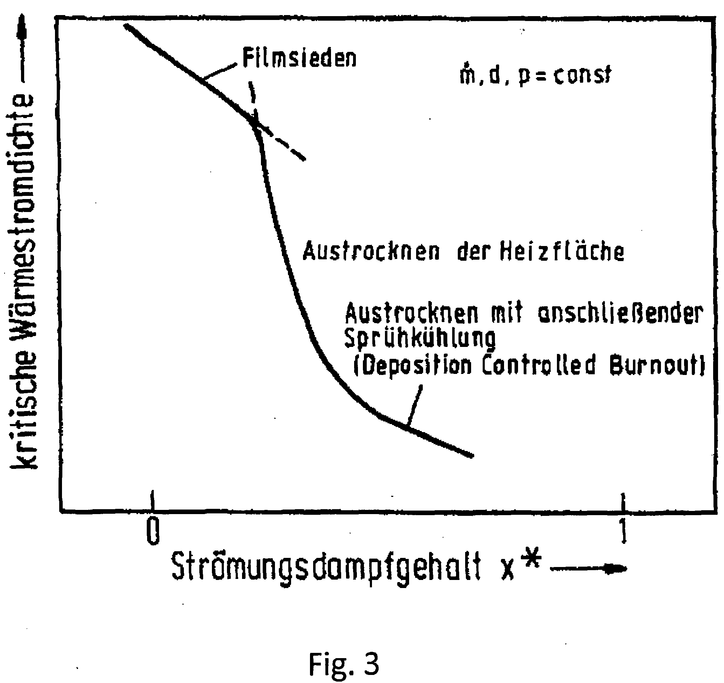

Fig. 3 zeigt die Abhängigkeit der kritischen Wärmestromdichte vom Dampfgehalt einer erzwungenen Zweiphasenströmung. Die Abbildung ist in Dieter Baehr, Karl Stephan, Wärme- und Stoffübertragung, 3. Auflage, Springer-Verlag, Abb. 4.55, Seite 505 enthalten. Je höher der Dampfgehalt ist, desto niedriger ist die kritische, Wärmestromdichte, umso schneller wird die Oberflächentemperatur des Kühlkörpers steigen. Die kritische Wärmestromdichte ist bei einer erzwungenen Zweiphasenströmung abhängig vom Dampfgehalt und kann sich von der maximalen Wärmestromdichte oder der freien Strömung unterscheiden.

## Patentansprüche

1. Kühlvorrichtung zur Abfuhr eines Wärmestroms mit einem Kühlkörper und einem Kühlmittel, das durch oder an dem Kühlkörper in einem Kühlmittelkreislauf geführt wird und in diesem verdampft, wobei der Kühlkörper mit einem Latentwärmespeicher in thermischer Verbindung steht, **dadurch gekennzeichnet, dass** ein Phasenwechselmaterial des Latentwärmespeichers eine Phasenübergangstemperatur mindestens 1K oberhalb einer Siedetemperatur des Kühlmittels besitzt, wobei bei einer Erwärmung des Kühlkörpers eine zwischen Kühlmittel und Kühlkörper auftretende Temperaturdifferenz kleiner oder gleich einer Temperaturdifferenz ist, bei der eine kritische Wärmestromdichte des Kühlmittels vorliegt.

2. Kühlvorrichtung nach Anspruch 1, **dadurch gekennzeichnet, dass** das Kühlmittel in einem Abschnitt des Kühlmittelkreislaufs verdampft.

3. Kühlvorrichtung nach einem der vorangehenden Ansprüche, **dadurch gekennzeichnet, dass** der Kühlkörper ein Gehäuse aufweist, in dem der Latentwärmespeicher angeordnet ist, wobei ein Abschnitt des Kühlmittelkreislaufs durch und/oder auf dem Latentwärmespeicher verläuft.

4. Kühlvorrichtung nach einem der vorangehenden Ansprüche, **dadurch gekennzeichnet, dass** in dem Phasenwechselmaterial des Latentwärmespeichers eine Wärmeleitstruktur vorgesehen ist, die einen in den Kühlkörper eintretende Wärmemenge verteilt.

5. Kühlvorrichtung nach Anspruch 4, **dadurch gekennzeichnet, dass** der Kühlmittelkreislauf durch das Phasenwechselmaterial verläuft und in thermischem Kontakt mit der Wärmeleitstruktur steht.

6. Kühlvorrichtung nach Anspruch 4 oder 5, **dadurch gekennzeichnet, dass** das Material für die Wärmeleitstruktur Aluminium, Kupfer und/oder Kohlefasermaterial vorgesehen ist.

7. Kühlvorrichtung nach einem der Ansprüche 1 bis 6, **dadurch gekennzeichnet, dass** die Phasenübergangstemperatur zwischen 50°C und 100°C vorgesehen ist.

8. Kühlvorrichtung nach einem der Ansprüche 1 bis 7, **dadurch gekennzeichnet, dass** der Kühlkörper, ausgehend von einer Betriebstemperatur, durch eine Wärmelast erwärmt wird.

9. Kühlvorrichtung nach Anspruch 8, **dadurch gekennzeichnet, dass** die Betriebstemperatur kleiner als 90°C ist.

10. Kühlvorrichtung nach einem der Ansprüche 1 bis 9, **dadurch gekennzeichnet, dass** die Erwärmung durch eine bei Betriebstemperatur einsetzende Wärmelast erfolgt, wobei die Betriebstemperatur kleiner als 90°C ist.

## Claims

1. A cooling unit for discharging a heat flux, with a heat sink and a coolant which is guided in a coolant circuit through or on the heat sink and evaporates in it, wherein the heat sink is in thermal communication with a latent heat accumulator, **characterised in that** a phase change material of the latent heat accumulator has a phase transition temperature of at least 1K above a boiling temperature of the coolant, wherein upon warming of the heat sink, a temperature difference occurring between coolant and heat sink is smaller than or equal to a temperature difference at which there is a critical heat flux density of the coolant.

2. The cooling unit according to claim 1, **characterised in that** the coolant evaporates in a section of the coolant circuit.

3. A cooling unit according to one of the preceding claims, **characterised in that** the heat sink has a housing in which the latent heat accumulator is arranged, wherein a section of the coolant circuit takes course through and/or on the latent heat accumulator.

4. A cooling unit according to any one of the preceding claims, **characterised in that** a heat conduction structure is provided in the phase change material of the latent heat accumulator, which dissipates a heat amount that enters into the heat sink.

5. The cooling unit according to claim 4, **characterised in that** the coolant circuit takes course through the phase change material and is in thermal contact with the heat conduction structure.

6. A cooling unit according to claim 4 or 5, **characterised in that** the material for the heat conduction structure is aluminium, copper and/or a carbon fibre material.

7. A cooling unit according to any one of the claims 1 to 6, **characterised in that** the phase transition temperature is provided to be between 50°C and 100°C.

8. A cooling unit according to any one of the claims 1 to 7, **characterised in that** starting from an operating temperature, the heat sink is heated by a thermal load.

9. The cooling unit according to claim 8, **characterised in that** the operating temperature is lower than 90°C.

10. A cooling unit according to any one of the claims 1 to 9, **characterised in that** the heating takes place by a thermal load starting at the operating temperature, the operating temperature being lower than 90°C.

## Revendications

1. Dispositif de refroidissement pour décharger un flux de chaleur, avec un dissipateur de chaleur et un agent de refroidissement qui est guidé dans un circuit d'agent de refroidissement à travers ou sur le dissipateur de chaleur et se vaporise dans celui-ci, le dissipateur de chaleur étant en communication thermique avec un accumulateur de chaleur latente, **caractérisé en ce que** un matériau à changement de phase de l'accumulateur de chaleur latente a une température de transition de phase d'au moins 1K au-dessus d'une température d'ébullition de l'agent de refroidissement, et que chez réchauffement du dissipateur de chaleur, une différence de température qui se produit entre l'agent de refroidissement et le dissipateur de chaleur est plus petite que ou égale à une différence de température chez laquelle il y a une densité de flux thermique critique de l'agent de refroidissement.

2. Dispositif de refroidissement selon la revendication 1, **caractérisé en ce que** l'agent de refroidissement se vaporise dans une section du circuit d'agent de refroidissement.

3. Dispositif de refroidissement selon l'une quelconque des revendications précédentes, **caractérisé en ce que** le dissipateur de chaleur a un boitier dans lequel l'accumulateur de chaleur latente est arrangé, une section du circuit d'agent de refroidissement s'étendant à travers et/ou sur l'accumulateur de chaleur latente.

4. Dispositif de refroidissement selon l'une quelconque des revendications précédentes, **caractérisé en ce que** une structure de transfert thermique est prévue dans le matériau à changement de phase de l'accumulateur de chaleur latente, qui disperse une quantité de chaleur qui entre dans le dissipateur de chaleur.

5. Dispositif de refroidissement selon la revendication 4, **caractérisé en ce que** le circuit d'agent de refroidissement passe à travers le matériau à changement de phase et est en contact thermique avec la structure de transfert thermique.

6. Dispositif de refroidissement selon la revendication 4 ou 5, **caractérisé en ce que** de l'aluminium, du cuivre et/ou un matériau en fibres de carbone est prévu comme le matériau pour la structure de transfert thermique.

7. Dispositif de refroidissement selon l'une quelconque des revendications 1 à 6, **caractérisé en ce que** la température de transition de phase est prévue entre 50°C et 100°C.

8. Dispositif de refroidissement selon l'une quelconque des revendications 1 à 7, **caractérisé en ce que** à partir d'une température de fonctionnement, le dissipateur de chaleur est chauffé par une charge thermique.

9. Dispositif de refroidissement selon la revendication 8, **caractérisé en ce que** la température de fonctionnement est plus basse que 90°C.

10. Dispositif de refroidissement selon l'une quelconque des revendications 1 à 9, **caractérisé en ce que** le réchauffement prend place par une charge thermique qui commence chez la température de fonctionnement, la température de fonctionnement étant plus basse que 90°C.
